# EUROPÄISCHE PATENTANMELDUNG

(11) **EP 0 859 541 A2**
(43) Veröffentlichungstag der Anmeldung: **19.08.1998**
(21) Anmeldenummer: 98102438.3
(22) Anmeldetag: 12.02.1998
(51) Int. Cl.: H05K 13/02

(54) **Zuführeinheit für einen Bestückungsautomaten**

(30) Priorität: 18.02.1997 CH 359/97
(71) Anmelder: Zevatech Trading AG, 2545 Selzach (CH)
(72) Erfinder: Gfeller, Martin, 3314 Schalunen (CH); Christen, Otto, 4702 Oensingen (CH); Grunder, Emil, 4614 Hägendorf (CH)
(74) Vertreter: Zinnecker, Armin, Dipl.-Ing.

(57) **Zusammenfassung**

Bei einer Zuführeinheit (1) für einen Bestückungsautomaten wird ein Bauelemente für die Bestückung enthaltendes, aus Trägerband und Deckband (22) bestehendes Band (23) in einer ersten Richtung schrittweise zu einer Entnahmestelle (13) für die Bauelemente transportiert. Das Deckband (22) wird an einer Abziehvorrichtung (12) vor der Entnahmestelle (13) von dem Trägerband mittels einer Antriebseinheit (6) oberhalb des Bandes (23) in einer zweiten Richtung abgezogen, welche der ersten Richtung im wesentlichen entgegengesetzt ist. Das Deckband (22) wird dann in einem Abstand hinter der Abziehvorrichtung (12) nach unten umgelenkt, in der Bandachse gedreht, und an dem Band (23) vorbei aus der Zuführeinheit (1) nach unten herausgeführt. Eine vereinfachte Bandführung und Einfädelung des Bandes wird dadurch erreicht, dass für die Umlenkung und Drehung des Deckbandes (22) ein gemeinsames Umlenkelement (5) vorgesehen ist.

## Beschreibung

### TECHNISCHES GEBIET

Die vorliegende Erfindung bezieht sich auf das Gebiet der automatischen Bestückungstechnik. Sie betrifft eine Zuführeinheit für einen Bestückungsautomaten, bei welcher Zuführeinheit ein Bauelemente für die Bestückung enthaltendes Band, welches ein Trägerband mit Taschen für die Aufnahme der Bauelemente und ein die Taschen mit den Bauelementen abdeckendes Deckband umfasst, in einer ersten Richtung schrittweise zu einer Entnahmestelle für die Bauelemente transportiert wird, bei welcher Zuführeinheit weiterhin das Deckband an einer Abziehvorrichtung vor der Entnahmestelle von dem Trägerband mittels einer Antriebseinheit oberhalb des Bandes in einer zweiten Richtung abgezogen wird, welche der ersten Richtung im wesentlichen entgegengesetzt ist, und bei welcher Zuführeinheit das Deckband in einem Abstand hinter der Abziehvorrichtung nach unten umgelenkt, in der Bandachse gedreht, und an dem Band vorbei aus der Zuführeinheit nach unten herausgeführt wird.

Eine solche Zuführeinheit ist beispielsweise aus der US-A-5,213,653 bekannt.

### STAND DER TECHNIK

Die automatische Bestückung von elektronischen Schaltungen (PCBs oder dgl.) mittels Bestückungsautomaten ist seit langem bekannt und wird insbesondere dort eingesetzt, wo komplizierte und umfangreiche Schaltungen auch in grosser Stückzahl schnell, effizient und fehlerfrei mit einer grösseren Anzahl von Bauelementen bestückt werden müssen. Die Bauelemente liegen dabei nach Typen getrennt auf einzelnen Bändern vor, die auf Spulen aufgerollt sind und mittels entsprechender Zuführeinheiten (Feeder) schrittweise an einer Entnahmestelle (Pick-up position) vorbeigeführt werden, wo sie von einem Handhabungsautomaten entnommen und an dem zugewiesenen Platz in der Schaltung abgesetzt werden. Die Bauelemente sind dabei auf dem Band einzeln in periodisch hintereinander angeordneten Taschen untergebracht und üblicherweise durch ein darüberliegendes Deckband gegen Herausfallen oder Beschädigung geschützt. Derartige automatische Bestückungsvorrichtungen sind beispielsweise aus den US-Patenten 4,610,083, 4,653,664, 5,191,693, 5,289,625 und 5,515,600 bekannt.

Da die zu bestückenden elektronischen Schaltungen in der Regel eine Vielzahl von unterschiedlichen Bauelementen enthalten und für jedes Bauelement in der Regel eine einzelne Zuführeinheit am Bestückungsautomaten benötigt wird, werden die Zuführeinheiten (Feeder) platzsparend in möglichst schmaler Bauweise ausgeführt, damit eine möglichst grosse Anzahl von ihnen nebeneinander am Bestückungsautomaten eingesetzt und von der Entnahmevorrichtung des Bestückungsautomaten in kurzer Zeit erreicht werden können (siehe dazu z.B. die Figuren aus der US-A-5,515,600 oder Fig. 13 aus der EP-A2-0 476 577). Die Mindestbreite der Zuführeinheit wird dabei massgeblich von der Breite des eingesetzten Bandes für die Bauelemente mitbestimmt.

Weiterhin ist es wichtig, dass bei den Zuführeinheiten die Spulen mit den Bauelement-Bändern schnell und einfach zu wechseln sind, um Unterbrechungen und Stillstandszeiten in der Bestückung möglichst zu vermeiden. Dazu gehört insbesondere auch das Einfädeln des Bandanfangs bzw. Deckbandanfangs. Da die Bauelement-Bänder aus dem Trägerband und dem Deckband bestehen, muss das Deckband vor der Entnahmestelle vom Trägerband abgezogen und entweder auf eine Leerspule aufgerollt oder aus der Zuführeinheit zur weiteren Entsorgung herausgeführt werden. Das Aufspulen des abgezogenen Deckbandes auf eine Leerspule, wie es in der Fig. 1 der eingangs genannten US-A-5,213,653 dargestellt und seit langem praktiziert wird, hat den Vorteil, dass die Führung des Deckbandes einfach gehalten werden kann. Entsprechend einfach ist beim Einlegen eines neuen Bandes auch das Einfädeln des Deckbandes. Nachteilig ist bei dieser Art der Deckbandentsorgung jedoch, dass die zusätzliche Leerspule für das Deckband, die meist oberhalb der Zuführeinheit angeordnet ist, nicht nur erheblichen zusätzlichen Platz beansprucht und im Hinblick auf die Entnahmevorrichtung störend wirkt, sondern dass die Spule, weil sie zwangsläufig nur einen kleinen Durchmesser aufweist, auch häufig gewechselt (und ggf. wieder abgespult) werden muss, wodurch ein erheblicher zusätzlicher Bedienungsaufwand anfällt.

Es ist daher bereits in einem früheren Patent der Anmelderin (US-A-5,204,720) vorgeschlagen worden, das Deckband direkt an einer schräggestellten Abziehkante (64) seitlich heraus und um eine horizontal angeordnete Rolle (66) nach unten umzulenken und zusammen mit dem leeren Trägerband nach unten aus der Zuführeinheit als loses Band herauszuführen. Als Antriebseinheit für das Deckband dient dabei dieselbe Antriebseinheit, die auch für den schrittweisen Transport des Trägerbandes verwendet wird. Durch den Wegfall jeglicher Leerspulen für Deckband und leeres Trägerband und die spezielle Art der Bandführung wird ein extrem kompakter Aufbau der Zuführeinheit erreicht, der gerade bei beengten Platzverhältnissen am Bestückungsautomaten ganz wesentliche Vorteile mit sich bringt. Darüber hinaus kann der Bandabfall unterhalb der Zuführeinheit in Behälter auf einfache Weise gesammelt und entsorgt oder einer Wiederverwertung zugeführt werden.

Der kompakte Aufbau dieser Zuführeinheit bringt es jedoch mit sich, dass der Bandwechsel mit einer gewissen Sorgfalt durchgeführt werden muss, die unter den normalen Produktionsbedingungen nicht immer leicht einzuhalten ist. Auch haben die direkte Umlenkung des Deckbandes an der Abziehkante und der gemeinsame Antrieb zur Folge, dass die Bänder (Deckband und leeres Trägerband) praktisch direkt unterhalb der Entnahmestelle aus der Zuführeinheit herausgeführt sind. Es ist jedoch in der Praxis nicht selten wünschenswert, dass die Bänder von der Entnahmestelle weg weiter nach hinten versetzt aus der Zuführeinheit nach unten herausgeführt werden, damit mehr Platz für die Auffangbehälter der Bänder zur Verfügung steht. Eine nachträgliche, d.h. hinter der Antriebseinheit vorgenommene Umlenkung von der Entnahmestelle weg nach hinten wäre bei der Zuführeinheit gemäss der US-A-5,024,720 zwar für das leere Trägerband möglich, weil das Trägerband aufgrund seiner relativen Steifigkeit auch ohne einen weiteren Antrieb gut umzulenken wäre. Beim dünnen und flexiblen Deckband ist dies jedoch nicht möglich, weil sich sonst Schlaufen und dgl. bilden würden, und ein reibungsloser Austritt des Deckbandes aus der Zuführeinheit nicht gewährleistet wäre.

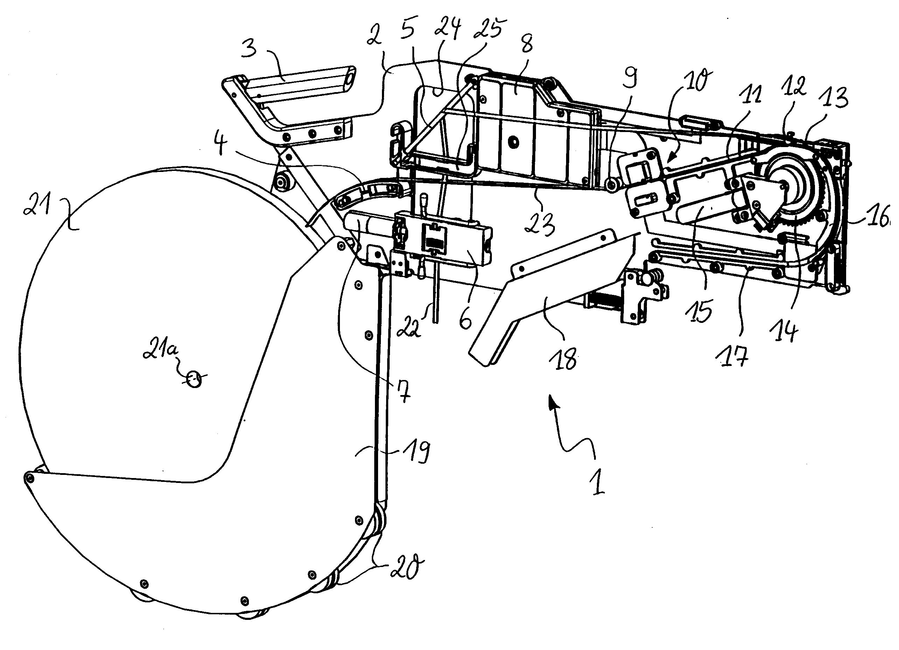

In einem späteren, auf der US-A-5,024,720 aufbauenden Patent, nämlich der eingangs genannten US-A-5,213,653, ist vorgeschlagen worden, das Deckband nach dem Abziehen zunächst entgegen der Richtung des Trägerbandes und oberhalb vom Trägerband von der Entnahmestelle wegzuführen, es dann nach unten umzulenken, um etwa 90° in der Bandachse zu drehen, am Trägerband im gedrehten Zustand vorbeizuführen, es wieder zurückzudrehen, und schliesslich nach unten aus der Zuführeinheit herauszuführen. Das leere Trägerband kann dabei ebenfalls nach hinten gelenkt und zusammen mit dem Deckband herausgeführt werden (Fig. 6). Eine am Ausgang des Deckbandes angeordnete Antriebseinheit (48, 49 in Fig. 2, 6) sorgt dafür, dass das abgezogene Deckband - obgleich es durch die ganze Zuführeinheit geführt wird - straff gehalten wird.

Für die Führung des abgezogenen Deckbandes ist bei der Lösung der US-A-5,213,653 eine Vielzahl von Führungselementen vorgesehen: In der Ausführungsform der Fig. 2 sind dies oberhalb des Trägerbandes die Umlenkrollen 32, 36 und 37, dann die Führungseinheit 38 für die Drehung des Deckbandes mit den versetzt angeordneten Rollen 42-44, und schliesslich unterhalb des Trägerbandes das Rollenpaar 46, 47. Hinzu kommt noch eine weitere Antriebseinheit 29, 31 oberhalb des Trägerbandes. In der Ausführungsform der Fig. 6 sind dies oberhalb des Trägerbandes die Umlenkrollen 32, 37, dann das Drehelement 102, 103, und unterhalb des Trägerbandes die Rolle 46. In beiden Fällen ist die Führung des Deckbandes aufwendig und kompliziert und bei einem Bandwechsel ist eine Einfädelung des Deckbandes zeitraubend. Zudem ist die Bandführung aufgrund ihres Aufbaus auf eine spezielle Bandbreite beschränkt, so dass mit derselben Zuführeinheit nicht ohne weiteres unterschiedliche Bandbreiten, die üblicherweise zwischen 8 mm und 56 mm variieren, verarbeitet werden können.

Eine weitere Zuführeinheit ist aus der DE-A1-35 44 221 bekannt. Bei dieser bekannten Zuführeinheit wird das abgezogene Abdeckband nach hinten über eine Rolle geführt und gleichzeitig nach unten umgelenkt. Die Rolle sitzt auf der Antriebsachse eines schrägstehenden Motors. Zwar sind in diesem Fall Antrieb und Umlenkung des Deckbandes vereinfachend miteinander kombiniert, jedoch bedingt der schrägstehende Motor nicht nur eine deutlich grössere Breite der Zuführeinheit, sondern das Deckband wird auch nicht in seiner Bandachse um etwa 90° Grad gedreht, was für eine platzsparende Vorbeiführung des Deckbandes am darunter verlaufenden Band notwendig ist. Zudem läuft das Deckband hinter dem Motor ohne weitere Zugspannung nach unten durch die Zuführeinheit, was bei dem dünnen flexiblen Deckband leicht zu Störungen im Bandlauf führen kann.

### DARSTELLUNG DER ERFINDUNG

Es ist nun Aufgabe der Erfindung, eine Zuführeinheit zu schaffen, welche die genannten Nachteile nicht aufweist, und insbesondere eine einfache und flexible Führung des Deckbandes umfasst, in welche das Deckband bei einem Bandwechsel auf einfache Weise eingelegt bzw. -gefädelt werden kann.

Die Aufgabe wird bei einer Zuführeinheit der eingangs genannten Art dadurch gelöst, dass für die Umlenkung und Drehung des Deckbandes ein gemeinsames Umlenkelement vorgesehen ist. Durch Verwendung des gemeinsamen Umlenkelementes für die Umlenkung und Drehung des Deckbandes kann die Anzahl der Umlenkelemente massgeblich reduziert werden, was zu einem stark vereinfachten Aufbau und einer erheblich vereinfachten Bedienung führt.

Eine erste bevorzugte Ausführungsform der erfindungsgemässen Zuführeinheit zeichnet sich dadurch aus, dass das Umlenkelement als feststehende, gerade Umlenkwelle ausgebildet ist, dass die Umlenkwelle in der Ebene des Bandes bzw. des Deckbandes liegt, und dass die Umlenkwelle mit der zweiten Richtung einen Winkel von ungefähr 45° einschliesst. Hierdurch ergibt sich neben der bestechenden Einfachheit der Führung eine hohe Betriebssicherheit, weil die Führung ohne bewegliche Teile wie Rollen und dgl. auskommt.

Eine bevorzugte Weiterbildung dieser Ausführungsform zeichnet sich dadurch aus, dass die Umlenkwelle zylindrisch ausgebildet ist, und dass die Umlenkwelle einen konstanten Aussendurchmesser und eine Länge aufweist, welche ein Mehrfaches der Mindestbreite des Deckbandes beträgt. Diese Ausbildung der Umlenkwelle hat zwei Vorteile: Zum einen können auf diese Weise ohne Umbau der Führung Deckbänder unterschiedlicher Breite verarbeitet werden. Zum anderen hat das umgelenkte Deckband in Richtung der Wellenachse der Umlenkwelle Spiel, was das Einfädeln stark erleichtert und eine Selbstzentrierung des umgelenkten Deckbandes ermöglicht.

Eine weitere bevorzugte Ausführungsform der Zuführeinheit nach der Erfindung ist dadurch gekennzeichnet, dass die Antriebseinheit für das Deckband in der Bandebene hinter dem Umlenkelement bzw. der Umlenkwelle angeordnet ist, dass das Band zwischen dem Umlenkelement bzw. der Umlenkwelle und der Antriebseinheit hindurchläuft, dass das Umlenkelement bzw. die Umlenkwelle und die Antriebseinheit auf einer parallel zur Ebene des Bandes angeordneten Grundplatte befestigt sind, dass im Bereich unterhalb des Umlenkelements bzw. der Umlenkwelle und zwischen dem Umlenkelement bzw. der Umlenkwelle und der Antriebseinheit in der Grundplatte eine Aussparung vorgesehen ist, und dass das Deckband in der Aussparung an dem Band vorbeigeführt wird. Die Anordnung der Antriebseinheit in der Bandebene, d.h. die Ausrichtung der Antriebsachse parallel zur Bandebene, macht es einerseits überflüssig, das Deckband vor der Antriebseinheit um die Bandachse wieder um 90° zurückzudrehen, wie dies beim Stand der Technik (US-A-5,213,653) der Fall ist. Andererseits können auf diese Weise bei beschränkter Dicke der Zuführeinheit auch grössere Bandbreiten problemlos angetrieben werden, weil die Antriebsbreite in der Bandebene ohne Schwierigkeiten vergrössert werden kann. Die Aussparung in der Grundplatte ermöglicht ein platzsparendes Vorbeiführen des Deckbandes am Band und erleichtert erheblich das Einfädeln des Deckbandes im Bereich der Umlenkwelle.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Die einzige Figur zeigt dabei in perspektivischer Darstellung ein bevorzugtes Ausführungsbeispiel einer erfindungsgemässen Zuführeinheit.

### WEGE ZUR AUSFÜHRUNG DER ERFINDUNG

In der einzigen Figur ist in perspektivischer Darstellung ein bevorzugtes Ausführungsbeispiel einer erfindungsgemässen Zuführeinheit wiedergegeben. Die Zuführeinheit 1 ist auf einer mit einem Griff 3 versehenen Grundplatte 2 aus Metall aufgebaut, an welche eine Spulenaufnahme 19 angeschraubt ist. Die Spulenaufnahme 19 ist nach oben hin offen. In sie kann eine Spule 21 mit dem aufgerollten, die Bauelemente enthaltenden Band eingesetzt werden und sich auf mehreren am unteren Rand der Spulenaufnahme 19 angeordneten Laufrollen 20 frei drehen. Der Achse 21a der Spule 21 kommt dabei keine Funktion zu. Das Band 23 wird aus der Spule 21 heraus durch den zentralen Teil der Zuführeinheit 1 nach vorne geführt, wo an einer Entnahmestelle 13 eine (nicht dargestellte) Entnahmevorrichtung eines (nicht dargestellten) Bestückungsautomaten die Bauteile entnimmt.

Unterhalb der Entnahmestelle 13 ist ein von einem Antriebsmotor 15 angetriebenes Transportrad 14 angeordnet. Das Transportrad 14 ist als Zahnrad ausgebildet und greift mit seinen Zähnen in entsprechende Perforationen im Band 23 ein. Der Transport des Bandes 23 durch das Transportrad 14 erfolgt schrittweise und wird von einer elektronischen Steuereinheit 8 gesteuert, die in der Zuführeinheit 1 untergebracht ist. Die Führung des Bandes 23 aus der Spule 21 heraus zum Transportrad 14 hin erfolgt über ein erstes, leicht gekrümmtes Führungselement 4, eine Umlenkrolle 9 und einen ersten Führungskanal 11. Zwischen der Umlenkrolle 9 und dem Eingang des ersten Führungskanals ist ein (optischer) Bandsensor 10 vorgesehen, der zur Detektion des Bandendes oder des Endes eines Bandabschnitts verwendet wird.

Das Band 23 besteht aus einem mit Taschen für die Bauelemente versehenen Trägerband, welches durch ein aufgeklebtes Deckband verschlossen ist. Vor der Entnahmestelle 13 wird mittels einer Abziehvorrichtung 12, wie sie beispielhaft in der US-A-5,213,653 beschrieben ist, das Deckband 22 entgegen der Laufrichtung des Bandes 23 nach hinten abgezogen. Das Trägerband wird hinter der Entnahmestelle 13 durch einen zweiten, gebogenen Führungskanal 16 um das Transportrad 14 herum und durch einen dritten, geraden Führungskanal 17 nach hinten geführt und durch ein weiteres Führungselement 18 nach unten aus der Zuführeinheit 1 herausgelenkt.

Das abgezogene Deckband 22 läuft ohne weitere Führung an der Steuereinheit 8 vorbei zu einer Umlenkwelle 5 und wird dort nach unten umgelenkt und zugleich in der Bandachse um 90° gedreht, so dass die Fläche des Deckbandes 22 hinter der Umlenkwelle 5 in etwa parallel zur Grundplatte 2 orientiert ist. Die kombinierte Umlenkung und Drehung des Deckbandes wird dadurch erreicht, dass die Umlenkwelle 5 in der Ebene des Bandes 23 bzw. des Deckbandes 22 liegt, und dass die Umlenkwelle 5 mit der Laufrichtung des abgezogenen Deckbandes 22 einen Winkel von ungefähr 45° einschliesst.

Die Umlenkwelle 5 ist vorzugsweise als feststehende, gerade und zylindrische Welle ausgebildet. Sie hat einen konstanten Aussendurchmesser und weist eine Länge auf, die ein Mehrfaches der Mindestbreite des Deckbandes 22 beträgt. Das Deckband 22 kann so beim Umlenken auf der Umlenkwelle 5 hin- und herrutschen. Dies führt einerseits im Zusammenhang mit der darunterliegenden Antriebseinheit zu einer Selbstzentrierung des Deckbandes 22, und andererseits kann das Deckband 22 beim Einlegen schnell und ohne weitere Präzision einfach um die Umlenkwelle 5 geschlungen werden, wodurch das Einlegen massgeblich erleichtert wird. Darüber hinaus kann dieselbe Umlenkwelle 5 ohne weiteren Umbau für verschiedene Breiten des Deckbandes 22 verwendet werden.

Die Umlenkwelle 5 ist etwas oberhalb der Grundplatte 2 angeordnet. Damit das umgelenkte Deckband 22 leicht um die Umlenkwelle 5 gelegt und unterhalb der Umlenkwelle 5 sicher an dem dort vorbeilaufenden Band 23 vorbeigeführt werden kann, ist unter der Umlenkwelle 5 und im Bereich zwischen der Umlenkwelle 5 und der Antriebseinheit 6 in der Grundplatte 2 eine Aussparung 24 vorgesehen. Das Deckband 22 wird in seiner um 90° gedrehten Orientierung in der Aussparung 24 an dem Band 23 vorbeigeführt. Zur Führung des Deckbandes 22 in der Aussparung 24 ist ein Führungselement vorgesehen, welches insbesondere die Form eines quer zur Richtung des Deckbandes 22 angeordneten, feststehenden Bügels 25 hat.

Das abgezogene Deckband 22 wird mittels einer von einem separaten Antriebsmotor 7 angetriebenen Antriebseinheit 6 transportiert (gezogen), die unterhalb des Bügels 25 am unteren Rand der Aussparung 24 angeordnet ist. Die Antriebseinheit 6 für das Deckband 22 liegt in der Bandebene, d.h., die Antriebsachse verläuft parallel zur Bandebene bzw. zur Grundplatte 2. Die Antriebsbreite der Antriebseinheit 6, welche die maximale Breite des zu transportierenden Deckbandes 22 bestimmt, kann so unabhängig von der Dicke der Zuführeinheit 1 frei gewählt werden. Vorzugsweise hat die Antriebseinheit 6 eine Antriebsbreite, die ein Mehrfaches der Mindestbreite des Deckbandes 22 beträgt, so dass einerseits auch Bänder mit grösseren Dicken ohne Aenderung transportiert werden können, und dass andererseits genügend Spiel für die Selbstzentrierung des Deckbandes 22 im Zusammenhang mit der Umlenkwelle 5 vorhanden ist. Zum Einlegen des Deckbandes 22 kann an der Antriebseinheit 6 in an sich bekannter Weise ein aufklappbares Oberteil geöffnet und anschliessend wieder geschlossen werden.

Insgesamt ergibt sich mit der Erfindung eine Zuführeinheit, die sich durch die folgenden Merkmale und Vorteile auszeichnet:
- Für den Abzug des Deckbandes ist nur ein Antrieb vorgesehen
- Die Umlenkung und Drehung des Deckbandes erfolgt über nur ein Umlenkelement in Form einer schrägstehenden (45°), in der Bandebene liegenden, länglichen Umlenkwelle
- Die Umlenkwelle bewirkt einen automatischen Zentriereffekt für Deckbandbreiten zwischen 8 und 56 mm
- Das Handling der Zuführeinheit ist sehr einfach, d.h., das Band bzw. das Deckband kann beim Bandwechsel sehr leicht und ohne grosse Präzision eingelegt bzw. eingefädelt werden
- Die Zuführeinheit ist robust: der Abzug des Deckbandes funktioniert auch, wenn das Deckband nicht korrekt eingelegt wurde
- Die Einfädelzeit und damit die Bandwechselzeit ist sehr kurz
- Der Aufbau der Zuführeinheit ist einfach und preisgünstig
- Durch Verzicht auf Rollen und andere bewegliche Führungselemente ist die Umlenkung weniger anfällig und weitgehend wartungsfrei.

### BEZEICHNUNGSLISTE

- 1: Zuführeinheit (Feeder)
- 2: Grundplatte
- 3: Griff
- 4: Führungselement (Band)
- 5: Umlenkwelle
- 6: Antriebseinheit (Deckband)
- 7: Antriebsmotor (Deckband]
- 8: Steuereinheit (elektronisch)
- 9: Umlenkrolle
- 10: Bandsensor
- 11,16,17: Führungskanal
- 12: Abziehvorrichtung (Deckband)
- 13: Entnahmestelle
- 14: Transportrad (Band)
- 15: Antriebsmotor (Band)
- 18: Führungselement (Trägerband)
- 19: Spulenaufnahme
- 20: Laufrolle
- 21: Spule
- 21a: Achse (Spule)
- 22: Deckband
- 23: Band
- 24: Aussparung
- 25: Bügel

## Patentansprüche

1. Zuführeinheit (1) für einen Bestückungsautomaten, bei welcher Zuführeinheit (1) ein Bauelemente für die Bestückung enthaltendes Band (23), welches ein Trägerband mit Taschen für die Aufnahme der Bauelemente und ein die Taschen mit den Bauelementen abdeckendes Deckband (22) umfasst, in einer ersten Richtung schrittweise zu einer Entnahmestelle (13) für die Bauelemente transportiert wird, bei welcher Zuführeinheit (1) weiterhin das Deckband (22) an einer Abziehvorrichtung (12) vor der Entnahmestelle (13) von dem Trägerband mittels einer Antriebseinheit (6) oberhalb des Bandes (23) in einer zweiten Richtung abgezogen wird, welche der ersten Richtung im wesentlichen entgegengesetzt ist, und bei welcher Zuführeinheit (1) das Deckband (22) in einem Abstand hinter der Abziehvorrichtung (12) nach unten umgelenkt, in der Bandachse gedreht, und an dem Band (23) vorbei aus der Zuführeinheit (1) nach unten herausgeführt wird, dadurch gekennzeichnet, dass für die Umlenkung und Drehung des Deckbandes (22) ein gemeinsames Umlenkelement (5) vorgesehen ist.

2. Zuführeinheit nach Anspruch 1, dadurch gekennzeichnet, dass das Umlenkelement als feststehende, gerade Umlenkwelle (5) ausgebildet ist.

3. Zuführeinheit nach Anspruch 2, dadurch gekennzeichnet, dass die Umlenkwelle (5) in der Ebene des Bandes (23) bzw. des Deckbandes (22) liegt, und dass die Umlenkwelle (5) mit der zweiten Richtung einen Winkel von ungefähr 45° einschliesst.

4. Zuführeinheit nach einem der Ansprüche 2 und 3, dadurch gekennzeichnet, dass die Umlenkwelle (5) zylindrisch ausgebildet ist, und dass die Umlenkwelle (5) einen konstanten Aussendurchmesser und eine Länge aufweist, welche ein Mehrfaches der Mindestbreite des Deckbandes (22) beträgt.

5. Zuführeinheit nach einem der Ansprüche 1 bis 4, dadurch gekennzeichnet, dass die Antriebseinheit (6) für das Deckband (22) in der Bandebene hinter dem Umlenkelement bzw. der Umlenkwelle (5) angeordnet ist, dass das Band (23) zwischen dem Umlenkelement bzw. der Umlenkwelle (5) und der Antriebseinheit (6) hindurchläuft.

6. Zuführeinheit nach Anspruch 5, dadurch gekennzeichnet, dass das Umlenkelement bzw. die Umlenkwelle (5) und die Antriebseinheit (6) auf einer parallel zur Ebene des Bandes (23) angeordneten Grundplatte (2) befestigt sind, dass unterhalb des Umlenkelements bzw. der Umlenkwelle (5) und im Bereich zwischen dem Umlenkelement bzw. der Umlenkwelle (5) und der Antriebseinheit (6) in der Grundplatte (2) eine Aussparung (24) vorgesehen ist, und dass das Deckband (22) in der Aussparung (24) an dem Band (23) vorbeigeführt wird.

7. Zuführeinheit nach Anspruch 6, dadurch gekennzeichnet, dass zur Führung des Deckbandes (22) in der Aussparung (24) ein Führungselement, insbesondere in Form eines quer zur Richtung des Deckbandes (22) angeordneten Bügels (25), vorgesehen ist.

8. Zuführeinheit nach einem der Ansprüche 1 bis 7, dadurch gekennzeichnet, dass die Antriebseinheit (6) für das Deckband (22) eine Antriebsbreite aufweist, die ein Mehrfaches der Mindestbreite des Deckbandes (22) beträgt.
